# EUROPEAN PATENT APPLICATION

(11) **EP 2 693 850 A1**
(43) Date of publication of application: **05.02.2014**
(21) Application number: 12763727.0
(22) Date of filing: 15.02.2012
(51) Int. Cl.: H05H 1/24, B01J 19/08, B08B 3/10, B26B 19/48, C01B 13/11, C02F 1/46, C02F 1/48, C02F 1/72, C02F 1/78

(54) **PLASMA GENERATOR AND CLEANING/PURIFICATION APPARATUS USING SAME**

(30) Priority: 28.03.2011 JP 2011069481
(71) Applicant: Panasonic Corporation, Osaka 571-8501 (JP)
(72) Inventor: SAITOH, Akihiko, Osaka-shi, Osaka 540-6207 (JP); SANEMATSU, Wataru, Osaka-shi, Osaka 540-6207 (JP); NARITA, Kenji, Osaka-shi, Osaka 540-6207 (JP); NAKAYAMA, Satoshi, Osaka-shi, Osaka 540-6207 (JP)
(74) Representative: Grünecker, Kinkeldey, Stockmair & Schwanhäusser
(86) International application number: PCT/JP2012/053508
(87) International publication number: WO 2012/132596

(57) **Abstract**

A plasma generator (1) comprises: a liquid containing part (3) which contains a liquid (6) including water; a gas containing part (4) which contains a gas; and a partition wall part (5) that separates the liquid containing part and the gas containing part from each other and is provided with a gas passage (5a) through which the gas in the gas containing part is led to the liquid containing part. The plasma generator (1) is also provided with a first electrode (10) that is arranged in the gas containing part and a second electrode (11) that is arranged so as to be in contact with the liquid in the liquid containing part. The plasma generator (1) is further provided with: a gas supply unit (9) which supplies the gas to the gas containing part; a plasma power supply unit (13); and a projected part (14) which serves as a drainage promotion part that prevents the liquid from remaining in the gas passage after the liquid in the liquid containing part is drained.

## Description

### TECHNICAL FIELD

The present invention relates to a plasma generator and a cleaning/purification apparatus using the same.

### BACKGROUND ART

As a conventional technique, an underwater electrical discharge device has been disclosed in Patent Literature 1. The underwater electrical discharge device performs electrical discharge in a liquid that contains bubbles, and thereby produces radicals and the like from the bubbles to modify the liquid.

### CITATION LIST

### PATENT LITERATURE

PTL 1: Japanese Patent Application Publication No. 2001-9463

### SUMMARY OF INVENTION

### TECHNICAL PROBLEM

The underwater electrical discharge device of this type needs to introduce a gas into a liquid in an electrical discharge container. For this reason, a small hole is provided in the container and the hole is used as a gas passage. If the liquid partially remains undrained in the gas passage after completion of the electrical discharge, the gas passage may be clogged with impurities such as calcium deposited through water evaporation, and stable electrical discharge may be failed.

In view of the above, an object of the present invention is to prevent a gas passage from being clogged after completion of electrical discharge, and thus to prevent occurrence of an unstable electrical discharge phenomenon due to the clogging.

### SOLUTION TO PROBLEM

A plasma generator according to a first aspect of the present invention comprises: a liquid containing part configured to contain a liquid which includes water; a gas containing part configured to contain a gas; a partition wall part separating the liquid containing part and the gas containing part from each other and including a gas passage configured to lead the gas in the gas containing part to the liquid containing part; a first electrode arranged in the gas containing part; a second electrode arranged in contact with the liquid in the liquid containing part; a gas supply unit configured to supply the gas including oxygen to the gas containing part in a way that the gas in the gas containing part is transferred to the liquid containing part through the gas passage by pressure; a plasma power supply unit configured to turn the gas, which is transferred into the liquid in the liquid containing part by pressure, into plasma by causing electrical discharge between the first electrode and the second electrode through application of a predetermined voltage between the first electrode and the second electrode; and a drainage promotion part configured to prevent the liquid in the liquid containing part from remaining in the gas passage after the liquid is drained.

The drainage promotion part may be may be formed from a projected part projecting from an opening peripheral portion of the gas passage beside the liquid containing part out from its surroundings.

At least an inner surface of the gas passage or the projected part may be formed from a hydrophobic member.

As the drainage promotion part, at least an opening peripheral portion of the gas passage beside the liquid containing part may be formed from a hydrophilic member.

The drainage promotion part may be formed from an air blowing mechanism configured to blow air to the gas passage.

The drainage promotion part may be formed from a vibration applying mechanism configured to apply vibrations to the gas passage.

The air blowing mechanism may use the gas to be supplied from the gas supply unit to the gas containing part.

The vibration applying mechanism may use vibrations originated from the gas supply unit.

A cleaning/purification apparatus according to a second aspect of the present invention comprises the plasma generator as described above.

### ADVANTAGEOUS EFFECTS OF INVENTION

The plasma generator of the present invention includes the drainage promotion part configured to prevent the liquid in the liquid containing part from remaining in the gas passage after the liquid is drained. Since the liquid does not remain in the gas passage after the drainage following the completion of the electrical discharge, deposition of impurities such as calcium through water evaporation is inhibited, and clogging of the gas passage is thus inhibited. Consequently, since the gas passage is prevented from being clogged with impurities, the plasma generator of the present invention is capable of obtaining stable electrical discharge.

In addition, when the cleaning/purification apparatus is equipped with the foregoing plasma generator, the cleaning/purification apparatus with higher cleaning effects can be realized since the stable plasma discharge can be obtained and radicals can be obtained stably.

### BRIEF DESCRIPTION OF DRAWINGS

[Fig. 1] Fig. 1 includes cross-sectional views schematically showing a plasma generator of a first embodiment, in which: Fig. 1(A) is an overall view of the plasma generator;
Fig. 1(B) is a magnified view of a gas passage portion; and Fig. 1(C) is a magnified view of the gas passage portion in a state where a liquid remains around the gas passage.
[Fig. 2] Fig. 2 is a partially magnified cross-sectional view schematically showing a state for explaining how the plasma generator of the first embodiment works.
[Fig. 3] Fig. 3 is a partially magnified cross-sectional view schematically showing a state following the state shown in Fig. 2.
[Fig. 4] Fig. 4 is a magnified cross-sectional view of the gas passage portion, showing another mode of a drainage promotion part of a plasma generator of a second embodiment.
[Fig. 5] Fig. 5 is a magnified cross-sectional view of the gas passage portion, showing yet another mode of the drainage promotion part of the plasma generator of the second embodiment.
[Fig. 6] Fig. 6 is a magnified cross-sectional view of the gas passage portion, showing still another mode of the drainage promotion part of a plasma generator of a third embodiment.
[Fig. 7] Fig. 7 is a magnified cross-sectional view of the gas passage portion, showing still another mode of the drainage promotion part of a plasma generator of a fourth embodiment.
[Fig. 8] Fig. 8 is a magnified cross-sectional view of the gas passage portion, showing still another mode of the drainage promotion part of a plasma generator of a fifth embodiment.
[Fig. 9] Fig. 9 is a magnified cross-sectional view of the gas passage portion, showing still another mode of the drainage promotion part of a plasma generator of a 6th embodiment.
[Fig. 10] Fig. 10 is a perspective view showing an example of how the plasma generator of one of the embodiments is applied to a cleaning/purification apparatus.
[Fig. 11] Fig. 11 is a cross-sectional view of the example shown in Fig. 10.
[Fig. 12] Fig. 12 is a cross-sectional view of the example taken along the A-A line of Fig. 11.

### DESCRIPTION OF EMBODIMENTS

Referring to the drawings, detailed descriptions will be hereinbelow provided for concrete embodiments to which the present invention is applied.

### [First Embodiment]

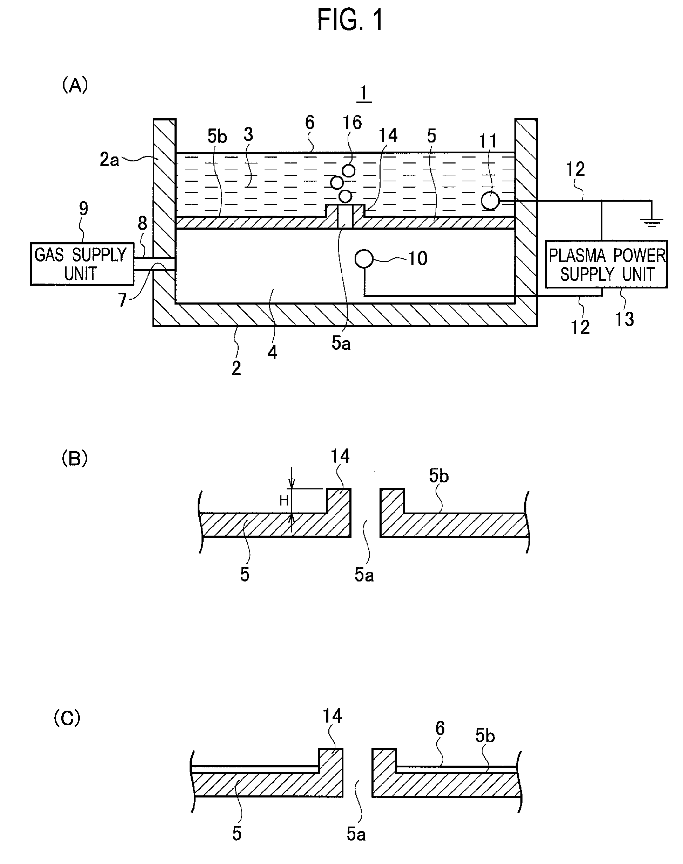

As shown in Fig. 1, a plasma generator 1 of a first embodiment includes a case member 2. The case member 2 is shaped like a cylinder or a square tube, for example. However, the shape of the case member 2 is not limited to the above. A partition wall part 5 configured to separate a liquid containing part 3 and a gas containing part 4 from each other is provided inside the case member 2. The internal space of the case member 2 is partitioned into upper and lower spaces by the partition wall part 5. In Fig. 1, the upper space is defined as the liquid containing part 3 and the lower space is defined as the gas containing part 4. A liquid 6 including water is contained in the liquid containing part 3. A gas including oxygen is contained in the gas containing part 4.

The partition wall part 5 is formed from a ceramic member, for example. The partition wall part 5 includes a gas passage 5a configured to guide the gas in the gas containing part 4 to the liquid containing part 3. The size of the gas passage 5a is set large enough for the gas to be sent into the liquid containing part 3 from the gas containing part 4. For this reason, the gas passage 5a should be as large in size as possible. If, however, the hole of the gas passage 5a is too large, the liquid 6 contained in the liquid containing part 3 flows into the gas containing part 4. For this reason, it is desirable that the gas passage 5a be made in a size large enough for the gas to be introduced into the liquid containing part 3, and for the liquid 6 to be prevented from flowing into the gas containing part 4 from the liquid containing part 3.

In this embodiment, the hole diameter of the gas passage 5a is set in a range of approximately 1 µm to 10 µm so that the liquid 6 contained in the liquid containing part 3 can be prevented from leaking out into the gas containing part 4 through the gas passage 5a.

A gas introduction port 7 making the gas containing part 4 communicate with the outside is provided in a sidewall 2a of the case member 2. A pipe (gas introduction passage) 8 is inserted in this gas introduction port 7. Thus, the gas containing part 4 is connected to a gas supply unit 9, which is provided outside the case member 2 through the pipe 8. In this embodiment, the gas including at least oxygen (O₂) is supplied to the inside of the gas containing part 4 from the gas supply unit 9. The gas supplied from the gas supply unit 9 is transferred into the liquid in the liquid containing part 3 through the gas passage 5a by pressure.

A first electrode 10 is arranged in the gas containing part 4. On the other hand, a second electrode 11 is arranged in the liquid containing part 3 while in contact with the liquid 6. The first electrode 10 and the second electrode 11 are configured to be respectively placed in the gas containing part 4 and the liquid containing part 3 with the partition wall part 5 interposed in between. Furthermore, neither the first electrode 10 nor the second electrode 11 is placed in contact with the partition wall part 5 or the case member 2. Moreover, each of the first electrode 10 and the second electrode 11 has a substantially spherical shape. The second electrode 11 is placed in contact with the liquid 6, and is earthed to the ground. Here, the shapes of the first electrode 10 and the second electrode 11 are not limited to the substantially spherical shapes.

Furthermore, the first electrode 10 and the second electrode 11 are electrically connected to a plasma power supply unit 13 respectively through lead lines 12. The plasma power supply unit 13 is designed to apply a predetermined voltage between the first electrode 10 and the second electrode 11. This voltage application causes electrical discharge between the first electrode 10 and the second electrode 11. This electrical discharge turns the gas, which is transferred into the liquid 6 in the liquid containing part 3 through the gas passage 5a by pressure, into plasma.

A drainage promotion part (drainage promotion means) prevents the liquid 6 in the liquid containing part 3 from remaining in the gas passage 5a after the liquid is drained. In the first embodiment, the drainage promotion part is formed from a projected part 14 which projects from an opening peripheral portion of the gas passage 5a beside the liquid containing part 3 out from its surroundings. The projected part 14 is formed into a shape of an annular wall or the like in a way that, in the opening peripheral portion of the gas passage 5a, the projected part 14 projects upward from one surface 5b of the partition wall part 5 which constitutes the bottom surface of the liquid containing part 3. When the hole shape of the gas passage 5a is not circular, the projected part 14 is formed not in the shape of the annular wall, but instead formed into a shape corresponding to the hole shape. The shape of the projected part 14 is not particularly limited.

It is desirable that the height H of the projected part 14 be set to a predetermined height above the one surface (the bottom surface of the liquid containing part 3) of the partition wall part 5 as shown in Fig. 1(B). If the height H of the projected part 14 is too low, the liquid 6 remains in the gas passage 5a after the drainage. Hence, when the gas passage 5a is dried up, impurities such as calcium are deposited through the water evaporation. Eventually, the gas passage 5a is clogged. On the other hand, if the height H of the projected part 14 is too high, the plasmatized gas is hard to diffuse into the liquid containing part 3. Here, the plasmatization takes place on an interface between the gas and the liquid. In this context, one may consider that the diffusion will not be obstructed by the height H of the projected part 14.

When the liquid 6 in the liquid containing part 3 is drained, the liquid 6 remains just a little on the one surface 5b of the partition wall part 5 as shown in Fig. 1(C). However, the liquid 6 does not remain in the gas passage 5a or its peripheral portion owing to the projected part 14. Without the projected part 14, the liquid 6 would remain covering the gas passage 5a by means of surface tension, and as the gas passage 5a is dried up, the gas passage 5a is clogged with impurities which are deposited through the water evaporation. Since, however, the projected part 14 functions as a breakwater, the liquid 6 does not remain in the gas passage 5a on the liquid containing part 3 side or its peripheral portion. Consequently, the gas passage 5a is prevented from being clogged with the impurities.

Next, descriptions will be provided for how the above-mentioned plasma generator 1 works, and for a method of producing hydroxyl radicals.

First of all, the gas including oxygen is supplied to the gas containing part 4 in a way that the gas in the gas containing part 4 is transferred to the liquid containing part 3 through the gas passage 5a by pressure (step of supplying a gas).

In this embodiment, the air-based gas including oxygen (with a flow rate of approximately 0.01 L/min to 1.0 L/min (10 cc/min to 1000 cc/min)) is sent into the gas containing part 4 from the gas supply unit 9 through the pipe 8. Here, the pressure for sending the gas in is controlled in a range of approximately 0.0098 MPa to 0.05 MPa.

As described above, the gas supply unit 9 has the function of supplying the gas (air) in the atmosphere. It should be noted that the flow rate for supplying the gas is controlled by a flow rate controller (not illustrated) provided to the gas supply unit 9. The gas supply unit 9 may include a function which enables the gas supply unit 9 to supply a different type of gas (for example, a gas with a different oxygen concentration) in addition to the gas in the atmosphere. Furthermore, the gas supply unit 9 may include a type-of-gas controller which enables the gas supply unit 9 to selectively supply one or more types of gases from various types of gases.

Once the gas is supplied to the gas containing part 4, the addition of this pressure to the atmospheric pressure raises the pressure in the gas containing part 4 to approximately 0.11 MPa to 0.05 MPa, and the gas containing part 4 is thus put into a positive pressure state. This positive pressure in the gas containing part 4 forms the flow of the gas from the gas containing part 4 to the liquid containing part 3 through the gas passage 5a.

Furthermore, the supply of the gas including oxygen in the above-mentioned manner makes fine bubbles 16 including oxygen grow at an opening end 15 of the gas passage 5a on the liquid containing part 3 side (step of growing bubbles).

Subsequently, the plasma power supply unit 13 applies a predetermined voltage between the first electrode 10 and the second electrode 11. Here, it is desirable that the applied voltage be a voltage (with power of approximately 10W to 100W) which enables glow discharge under the atmospheric pressure. In this respect, it is desirable that a voltage controller be provided to the plasma power supply unit 13 to control the voltage to be applied between the first electrode 10 and the second electrode 11.

Thereafter, the application of the predetermined voltage between the first electrode 10 and the second electrode 11 causes electrical discharge between the first electrode 10 and the second electrode 11 under the gas atmosphere whose pressure is equal to or higher than the atmospheric pressure. Incidentally, a technique for plasma generation under the atmospheric pressure has been reported in Document A (Okazaki, Sachiko, "Atmospheric Glow Discharge Plasma and Its Application," Review Speech at 20th JSPF Annual Meeting), for example.

Then, this electrical discharge generates plasma in the gaseous area in the liquid 6 in the liquid containing part 3, and thus produces ozone, hydroxyl radicals and the like from oxygen which is included in the water and gas included in the liquid 6 (step of producing hydroxyl radicals).

In the embodiment, the plasma is generated by causing a potential difference in the gas in the bubbles 16 (the gas near the gas-liquid interfaces in the liquid 6 in the liquid containing part 3). Since the potential difference is thus caused near the gas-liquid interfaces where hydroxyl radicals are easy to produce, it is possible to produce more ozone, hydroxyl radicals, and the like. It should be noted that this embodiment is capable of producing ozone, hydroxyl radicals and the like not only in the bubbles 16 near the opening end 15 of the gas passage 5a facing the liquid 6, but also in the bubbles 16 sent out to the liquid containing part 3.

The thus-produced ozone, hydroxyl radicals, etc. are sent out to the liquid containing part 3 in conjunction with the above-mentioned flow of the bubbles 16.

In the embodiment, the flow of the liquid 6 in the liquid containing part 3 detaches the bubbles 16 including hydroxyl radicals and the like from the partition wall part 5, and releases the thus-detached bubbles 16 into the liquid 6 (step of releasing the bubbles).

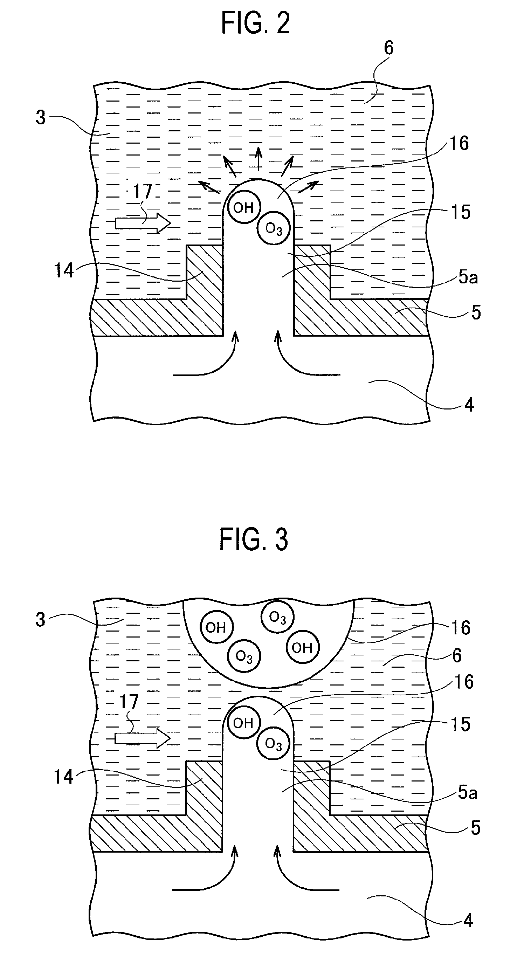

To put it specifically, the introduction of the liquid 6 causes the flow of the liquid 6 (see arrows 17 in Fig. 2 and Fig. 3) in the liquid containing part 3 where the bubbles 16 grow. As shown in Fig. 3, when the liquid 6 flowing in the direction indicated with the arrow 17 hits a growing bubble 16, the flow of the liquid 6 works as a detachment force, and the bubble 16 is thus set free into the liquid 6 from the opening end 15.

Since the bubbles 16 set free into the liquid 6 are fine bubbles, the bubbles 16 disperse throughout the liquid 6 without being directly released into the atmosphere. Parts of the dispersing fine bubbles 16 dissolve into the liquid 6. During this dissolution, ozone and the like included in the bubbles 16 dissolve into the liquid 6. Thus, the concentration of ozone in the liquid 6 rises quickly.

In addition, Document B (Masayoshi Takahashi, "Remediation of Water Environment by Microbubbles and Nanobubbles," Aqua Net, June 2004) has reported that, in general, the fine bubbles 16 including ozone and various radicals are usually negatively charged. Accordingly, parts of the bubbles 16 are attracted to organic matters, fats and oils, dyes, proteins, bacteria, and the like which are included in the liquid 6. The organic matters and the like in the liquid 6 are decomposed by ozone or various radicals which dissolve in the liquid 6, as well as ozone, various radicals or the like which are included in the bubbles 16 attracted to the organic matters and the like.

Hydroxyl radicals and the like have relatively large energy of approximately 120 kcal/mol, for example. This energy is larger than the binding energy (100 kcal/mol or less) of the double bond (N=N) between nitrogen atoms, the double bond (C=C) between carbon atoms, the double bond (C=N) between a carbon atom and a nitrogen atom, and the like. For this reason, the organic matters made by the bonds of nitrogen, carbon and the like are decomposed with their bonds easily broken by the hydroxyl radicals and the like. The ozone, hydroxyl radicals and the like which contribute to the decomposition of the organic matters and the like have no persistence unlike chlorine and the like, and disappear with a lapse of time. For this reason, the ozone, hydroxyl radicals and the like are also environment-friendly substances.

As described above, in the plasma generator 1 of the first embodiment, the first electrode 10 is arranged in the gas containing part 4 while the second electrode 11 is arranged in contact with the liquid 6 in the liquid containing part 3. In addition, the electrical discharge is caused between the first electrode 10 and the second electrode 11. Thereby, the plasma is generated in the gaseous area in the liquid 6 in the liquid containing part 3, and the hydroxyl radicals are produced from oxygen included in the water and gas which are included in the liquid 6.

This configuration makes it possible to cause the electrical discharge between the first electrode 10 and the second electrode 11 without being subjected to the influence of electric resistance of the liquid 6 so much. As a result, the gas can be securely turned into plasma, whereby ozone, radicals and the like can be more stably produced in large amounts. When the plasma generator 1 is used as a cleaning/purification apparatus, the electric resistance value of the liquid 6 fluctuates to a large extent because impurities and the like are included in the water in the liquid 6. The plasma generator 1 of the first embodiment, however, is capable of restricting the fluctuation in the electrical discharge since the plasma generator 1 is less subjected to the influence of the electric resistance of the liquid 6 for the above-described reason. Accordingly, the plasma generator 1 is capable of stably generating the plasma, and thereby stably obtaining the radicals and the like.

Furthermore, since the first embodiment includes the projected part 14 configured to prevent the liquid 6 in the liquid containing part 3 from remaining in the gas passage 5a after the liquid 6 is drained, the projected part 14 serves as the breakwater so as to prevent the liquid 6 from remaining in the gas passage 5a and its peripheral portion. Consequently, it is possible to avoid the deposition of the impurities such as calcium which occurs through the water evaporation as the liquid 6 dries out, and the resultant clogging of the gas passage 5a with the impurities. Accordingly, the stable electrical discharge can be obtained; the gas can be securely turned into plasma; the ozone, the radicals and the like can be stably produced in large amounts; and cleaning/purification actions can be enhanced.

In addition, in the first embodiment, the introduction of the gas including oxygen into the gas containing part 4 makes the pressure in the gas containing part 4 positive, and forms the flow of the gas from the gas containing part 4 to the liquid containing part 3 through the gas passage 5a. The ozone, the hydroxyl radicals and the like are produced in the bubbles 16 which grow at the opening end 15 of the gas passage 5a facing the liquid 6 in conjunction with the flow of the gas.

In other words, in the first embodiment, the ozone, the hydroxyl radicals and the like are produced in the gas in the bubbles 16 (the gas near the gas-liquid interfaces in the liquid 6 in the liquid containing part 3). In addition, the gas including the ozone, the hydroxyl radicals and the like is designed to be dispersed as the fine bubbles 16 throughout the liquid 6. Thereby, after the ozone and the various radicals are produced, the ozone and the various radicals can be sent into the liquid 6 efficiently in a very short length of time before the ozone and the various radicals disappear.

Thus, the fine bubbles 16 including the ozone and the various radicals disperse throughout the liquid 6. This dispersion increases the concentration of the ozone in the liquid 6, and the bubbles 16 are attracted to the organic matters and the like which are included in the liquid 6. Thereby, the organic matters, the bacteria and the like can be efficiently decomposed by the ozone which dissolves into the liquid 6, and the various radicals included in the attracted bubbles 16.

What is more, in the plasma generator 1 of the first embodiment, the voltage is applied between the first electrode 10 and the second electrode 11 with the second electrode 11 earthed. For this reason, even if a user of the plasma generator 1 or someone else accidentally touches the liquid 6 or the second electrode 11, it is still possible to prevent him or her from an electric shock.

Besides, the plasma generator 1 of the first embodiment is capable of stably causing the electrical discharge, if the plasma power supply unit 13 includes the voltage control unit configured to control the voltage to be applied between the first electrode 10 and the second electrode 11. In other words, even if the electric resistance of the liquid 6 fluctuates, the stable electrical discharge can be obtained by changing the voltage in accordance with the fluctuation.

In addition, the plasma generator 1 of the first embodiment is capable of controlling the amount of ozone to be produced, the amount of hydroxyl radicals to be produced, and the like, if the gas supply unit 9 includes the type-of-gas controller configured to control the types of gases.

Furthermore, the plasma generator 1 of the first embodiment is capable of supplying the gas more simply and easily, if the gas supply unit 9 has the function of supplying the air in the atmosphere.

Moreover, the plasma generator 1 of the first embodiment is capable of generating the plasma more stably, if the flow rate for supplying the gas is controlled by the flow rate controller.

### [Second Embodiment]

In a plasma generator 1 of a second embodiment, a projected part 14 has a different shape from that of the projected part 14 of the plasma generator 1 of the first embodiment. The plasma generator 1 of the second embodiment is the same as the plasma generator 1 of the first embodiment, except for the difference in the shape of the projected part 14. For this reason, components which are the same as those of the first embodiment will be denoted by the same reference signs, and descriptions for such components will be omitted.

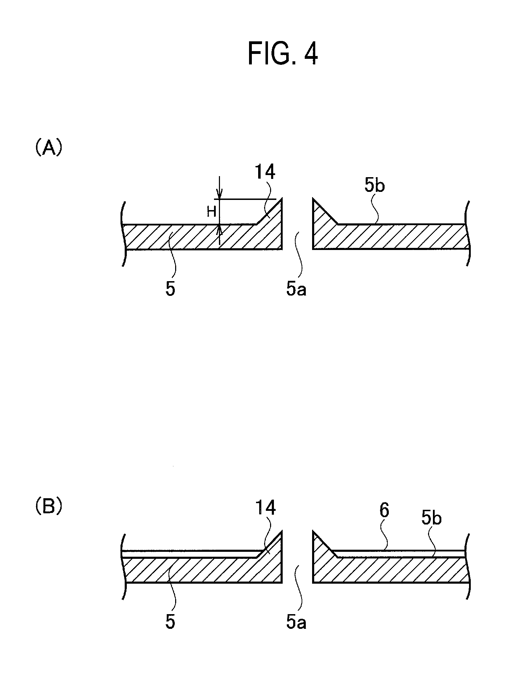

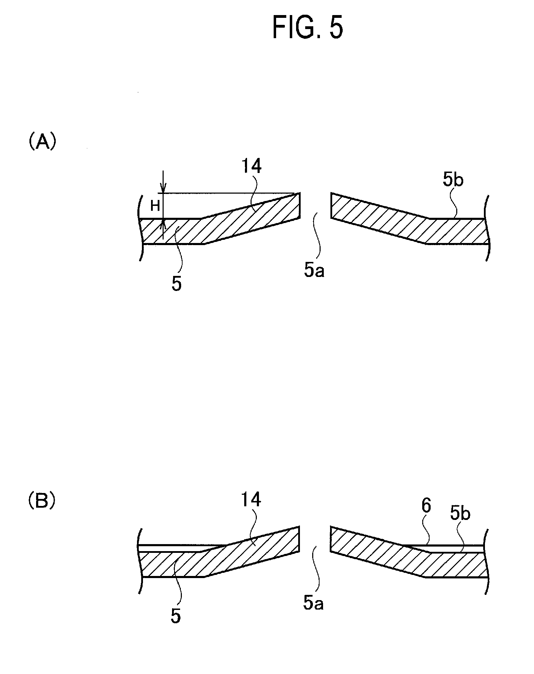

Fig. 4 and Fig. 5 show the projected parts 14 of the plasma generator 1 of the second embodiment. The projected part 14 shown in Fig. 4 is formed as a mountain-shaped projection which becomes gradually higher in height from the outer periphery of a gas passage 5a toward its center. The projected part 14 shown in Fig. 5 is shaped like a mountain which gently becomes higher in height from its outer periphery toward its center, but unlike a steep mountain as shown in Fig. 4.

As in the case of the first embodiment, the projected parts 14 shown in Fig. 4 and Fig. 5 serve as the breakwater so as to prevent the liquid 6 from remaining in the gas passage 5a and its peripheral portion. Consequently, it is possible to avoid the deposition of the impurities such as calcium which occurs through the water evaporation as a liquid 6 dries out, and the resultant clogging of the gas passage 5a with the impurities. Accordingly, the stable electrical discharge can be obtained, and the gas can be securely turned into plasma. Furthermore, the ozone, the radicals and the like can be stably produced in large amounts, and the cleaning/purification actions can be enhanced.

### [Third Embodiment]

In a plasma generator 1 of a third embodiment, at least the projected part 14 of the first embodiment or the inner surface of the gas passage 5a in the projected part 14 is formed from a hydrophobic member 18. The plasma generator 1 of the third embodiment is the same as the plasma generator 1 of the first embodiment, except that the inner surface of the gas passage 5a or the projected part 14 is formed from the hydrophobic member 18. For this reason, components which are the same as those of the first embodiment will be denoted by the same reference signs, and descriptions for such components will be omitted.

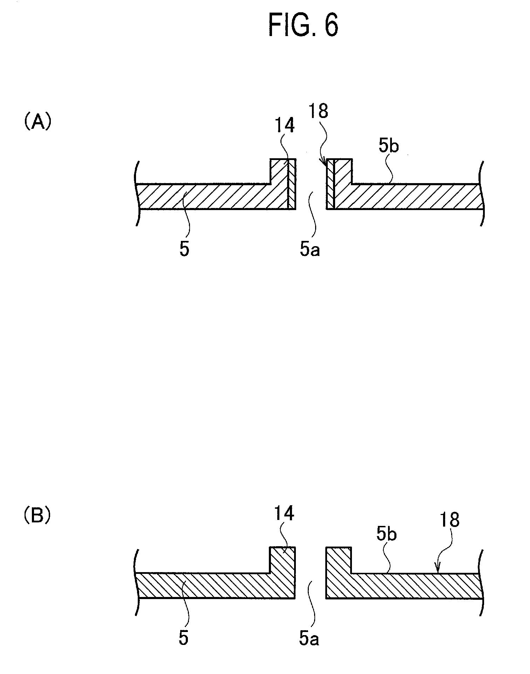

Fig. 6 shows projected parts 14 of the plasma generator 1 of the third embodiment. In Fig. 6(A), the entire inner surface of the gas passage 5a, including the inner surface of the projected part 14, is formed from the hydrophobic member 18. In Fig. 6(B), the entire partition wall part 5, including the projected part 14, is formed from the hydrophobic member 18. The hydrophobic member 18 is a highly water-repellent substance having higher surface free energy (surface tension). An example of the hydrophobic member 18 can be realized with a surface shape of a highly water-repellent microstructure such as a fractal structure using the Koch curve.

Alternatively, the hydrophobic member 18 is made from, for example, PTFE (polytetrafluoroethylene), a fluororesin, a fluorine-containing aqueous coating material (Fluoro Surf produced by Fluoro Technology) or the like. Otherwise, the hydrophobic member 18 is made from silyl ether, a substance containing an alkylsilyl group, or the like. Furthermore, saturated fluoroalkyl groups (particularly, a trifluoromethyl group CF3-), alkylsilyl groups, fluorosilyl groups, long-chain alkyl groups and the like may be used for the hydrophobic member 18.

When the entire inner wall of the gas passage 5a including the inner wall of the projected part 14 is formed from the hydrophobic member 18 as shown in Fig. 6(A), a film of one of the hydrophobic materials is formed by application, dip coating, spin coating, plating, vapor deposition, sputtering, or the like. The same applies to the case where the entire partition wall part 5 including the inner wall of the projected part 14 is formed from the hydrophobic member 18 as shown in Fig. 6(B).

In the third embodiment, the projected part 14 serves as the breakwater so as to prevent a liquid 6 from remaining in the gas passage 5a and its peripheral portion. In addition, even if the liquid 6 adheres to the inside of the gas passage 5a, the water repellent effect does not allow the liquid 6 to remain in the gas passage 5a. For this reason, even if impurities such as calcium are deposited through water evaporation as the liquid 6 dries out, the gas passage 5a will not be clogged with the impurities. Accordingly, the stable electrical discharge can be obtained, and the gas can be securely turned into plasma. Furthermore, the ozone, the radicals and the like can be stably produced in large amounts, and the cleaning/purification action can be enhanced.

### [Fourth Embodiment]

In a plasma generator 1 of a fourth embodiment, at least an opening peripheral portion of a gas passage 5a on a liquid containing part 3 is formed from a hydrophilic member 19 as the drainage promotion part. The plasma generator 1 of the fourth embodiment is the same as the example shown in Fig. 4, except that at least the opening peripheral portion of the gas passage 5a is formed from the hydrophilic member 19. For this reason, components which are the same as those shown in Fig. 4 will be denoted by the same reference signs, and descriptions for such components will be omitted.

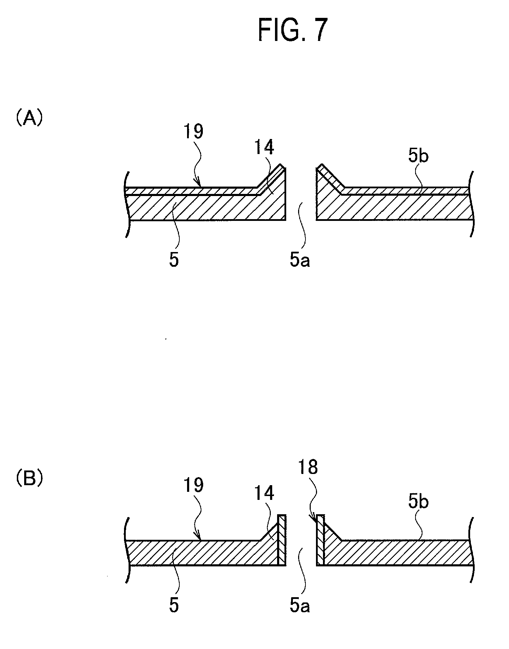

In Fig. 7(A), one surface 5b of a partition wall part 5, including the projected part 14 shaped like a mountain which becomes gradually higher in height from the outer periphery of the gas passage 5a toward its center, is formed entirely from the hydrophilic member 19. In other words, the entire bottom surface of the partition wall part 5 including the opening peripheral portion of the gas passage 5a is formed from the hydrophilic member 19. In Fig. 7(B), the entire partition wall part 5 is formed from the hydrophilic member 19, whereas the inner surface of the gas passage 5a is formed from a hydrophobic member 18.

A hydrophilic material, such as titanium oxide (TiO₂) or aluminum oxide (Al₂O₃), is used for the hydrophilic member 19. In this embodiment, a hydrophilic fumed metal oxide produced by Nippon Aerosil Co., Ltd. is used as the hydrophilic material. The use of the hydrophilic member 19 enables absorption of a liquid 6 which slightly remains on the bottom surface of the partition wall part 5 after the drainage.

In the structure shown in Fig. 7(A), the liquid 6 tends to slightly remain on the bottom surface (the one surface 5b) of the partition wall part 5 after the drainage. Since, however, the entire bottom surface is formed from the hydrophilic member 19, the liquid 6 is absorbed by the hydrophilic member 19. On the other hand, in the structure shown in Fig. 7(B), the entire partition wall part 5 is similarly formed from the hydrophilic member 19. For this reason, the liquid 6 on the bottom surface is absorbed by the hydrophilic member 19. Furthermore, the inner surface of the gas passage 5a is formed from the hydrophobic material 18. For this reason, the liquid 6 is repelled from the gas passage 5a. Thereby, the fourth embodiment can prevent the liquid 6 from remaining in the gas passage 5a and its peripheral portion. Consequently, it is possible to avoid the deposition of the impurities such as calcium which occurs through the water evaporation as the liquid 6 dries out, and the resultant clogging of the gas passage 5a with the impurities. Accordingly, the stable electrical discharge can be obtained, and the gas can be securely turned into plasma. Furthermore, the ozone, the radicals and the like can be stably produced in large amounts, and the cleaning/purification effects can be enhanced.

### [Fifth Embodiment]

In a plasma generator 1 of a fifth embodiment, a drainage promotion part is formed from an air blowing mechanism configured to blow air to a gas passage part 5a. The plasma generator 1 of the fifth embodiment is the same as the plasma generator 1 of the first embodiment, except for the difference in the structure of the drainage promotion part and the absence of a projected part 14. For this reason, components which are the same as those of the first embodiment will be denoted by the same reference signs, and descriptions for such components will be omitted.

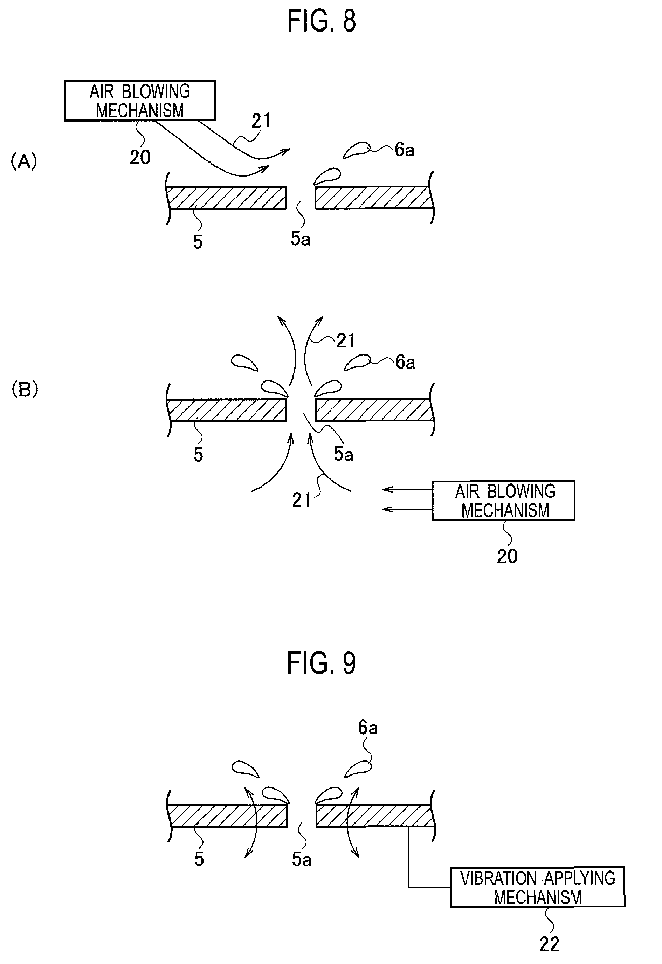

In Fig. 8(A), a blower or the like configured to blow the air is used as an air blowing mechanism 20, and the air blowing mechanism 20 blows away a liquid 6 in a gas passage 5a and its opening peripheral portion as water droplets 6a by blowing air 21 directly to a bottom surface of a liquid containing part 3. In Fig. 8(B), the air blowing mechanism 20 such as a blower provided in a gas containing part 4 blows away the liquid 6 in the gas passage 5a as the water droplets 6a by blowing the air 21 into the gas passage 5a toward the liquid containing part 3.

The blow of the air by any one of the air blowing mechanisms 20 shown in Figs. 8(A) and (B) causes the liquid 6 in the gas passage 5a to be blown away as the water droplets 6a, and makes it possible to prevent the liquid 6 from remaining in the gas passage 5a. Consequently, it is possible to avoid the deposition of the impurities such as calcium which occurs through the water evaporation as the liquid 6 dries out, and the resultant clogging of the gas passage 5a with the impurities. Accordingly, the stable electrical discharge can be obtained, and the gas can be securely turned into plasma. Furthermore, the ozone, the radicals and the like can be stably produced in large amounts, and the cleaning/purification actions can be enhanced.

### [6th Embodiment]

In a plasma generator 1 of a 6th embodiment, a drainage promotion part is formed from a vibration applying mechanism configured to apply vibrations to a gas passage 5a. The plasma generator 1 of the 6th embodiment is the same as the plasma generator 1 of the first embodiment, except for the difference in the structure of the drainage promotion part and the absence of a projected part 14. For this reason, components which are the same as those of the first embodiment will be denoted by the same reference signs, and descriptions for such components will be omitted.

In Fig. 9, a vibration applying mechanism 22 configured to apply vibrations to a partition wall part 5 is used. The vibration applying mechanism 22 applies vibrations directly to the partition wall part 5, and blows away a liquid 6 in a gas passage 5a and its opening peripheral portion as water droplets 6a by using the vibrations. A conventional general structure may be used as the vibration applying mechanism 22, and no specific restriction is imposed on the structure.

The vibration of the partition wall part 5 by the vibration applying mechanism 5 shown in Fig. 9 causes the liquid 6 in the gas passage 5a to be blown away as the water droplets 6a, and makes it possible to prevent the liquid 6 from remaining in the gas passage 5a. Consequently, it is possible to avoid the deposition of the impurities such as calcium which occurs through the water evaporation as the liquid 6 dries out, and the resultant clogging of the gas passage 5a with the impurities. Accordingly, the stable electrical discharge can be obtained, and the gas can be securely turned into plasma. Furthermore, the ozone, the radicals and the like can be stably produced in large amounts, and the cleaning/purification actions can be enhanced.

### [7th Embodiment]

In a plasma generator 1 of a 7th embodiment, a gas supply unit 9 is used also as the air blowing mechanism 20 of the fifth embodiment, or alternatively, the gas supply unit 9 is used also as the vibration applying mechanism 22 of the 6th embodiment. For this reason, the 7th embodiment will be described by use of Fig. 1, Fig. 8(B) and the Fig. 9.

The gas supply unit 9 configured to blow gas into a gas containing part 4 is used instead of the air blowing mechanism 20 shown in Fig. 8(B). To put it specifically, after a liquid 6 in a liquid containing part 3 is drained following a cleaning operation, the gas supply unit 9 is kept in operation and the gas is fed into a gas containing part 4. Thereby, the air is blown out to the liquid containing part 3 through the gas passage 5a. Thus, the liquid 6 in the gas passage 5a is blown away as water droplets 6a.

The gas supply unit 9 configured to blow the gas into the gas containing part 4 is used instead of the vibration applying mechanism 22 shown in Fig. 9. To put it specifically, after the liquid 6 in the liquid containing part 3 is drained following an cleaning operation, the gas supply unit 9 is kept in operation and vibrations generated in conjunction with the operation of the gas supply unit 9 are transmitted to a partition wall part 5 through a vibration transmitting member or the like. The liquid 6 in the gas passage 5a is removed by the vibrations.

In the 7th embodiment, the removal of the liquid 6 in the gas passage 5a makes it possible to avoid the deposition of the impurities such as calcium which occurs through the water evaporation as the liquid 6 dries out, and the resultant clogging of the gas passage 5a with the impurities. Accordingly, the stable electrical discharge can be obtained, and the gas can be securely turned into plasma. Furthermore, the ozone, the radicals and the like can be stably produced in large amounts, and the cleaning/purification actions can be enhanced. In addition, since the gas supply unit 9 is used also as the air blowing mechanism 20 or as the vibration applying mechanism 22, the 7th embodiment does not require specialized parts, thereby making it possible to reduce the size of the apparatus itself and to achieve cost reduction.

### [8th Embodiment]

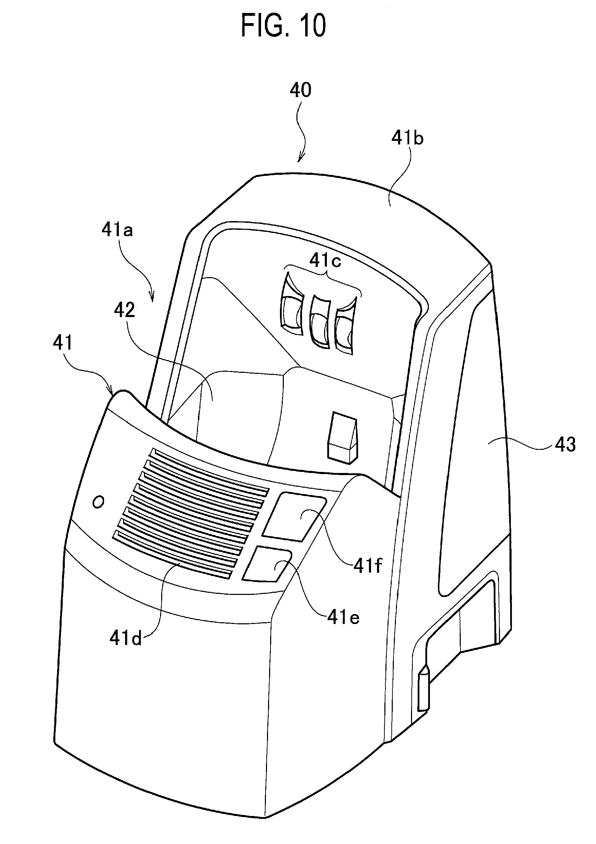

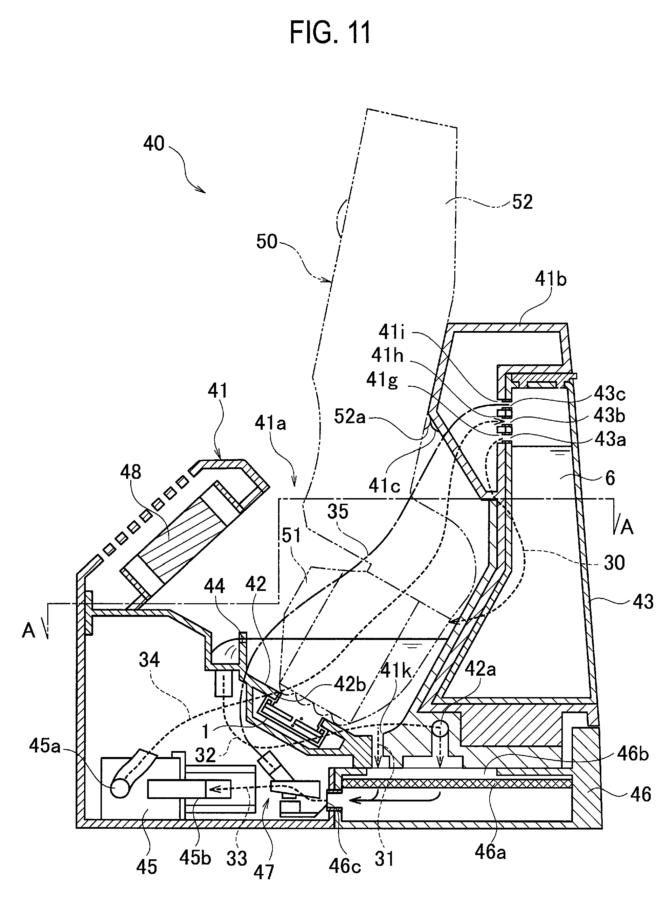

Descriptions will be provided for an 8th embodiment of the present invention by referring to Fig. 10 to Fig. 12. Here, a small-sized electric appliance using the plasma generator 1 will be discussed as an example of the 8th embodiment. The small-sized electric appliance is a cleaning/purification apparatus configured to clean a head unit of an electric shaver (a small-sized shaving tool).

A cleaning/purification apparatus 40 is configured to clean the head unit (an object to undergo a cleaning process) 51 of an electric shaver 50 which is a type of a shaving tool.

As shown in Fig. 10 to Fig. 12, the cleaning/purification apparatus 40 includes a housing 41 having an opening 41 a through which to insert the electric shaver 50 with the head unit 51 upended, and a receptacle 42 configured to receive the head unit 51 which is inserted into the housing 42 through the opening 41a.

The cleaning/purification apparatus 40 further includes: a tank 43 configured to hold the liquid 6; an overflow part 44 communicating with the receptacle 42; and a pump 45 configured to circulate and supply the liquid 6 in the tank 43 to an liquid introduction port. The cleaning/purification apparatus 40 yet further includes: a cartridge 46 having a filter 46a configured to filter the liquid; an on-off valve 47 configured to control the airtight state in the tank 43; and a circulation passage configured to circulate the liquid 6.

The circulation passage includes: a pipe (liquid introduction passage) 30 configured to introduce the liquid 6, which is held in the tank 43, to the receptacle 42; and a passage 31 (a discharge passage) configured to lead the liquid, which is discharged from the receptacle 42, to the cartridge 46. The circulation passage further includes: a passage 32 configured to lead the liquid 6, which is discharged from the overflow part 44, to the cartridge 46; and a passage 33 configured to lead the liquid 6, which is discharged from the cartridge 46, to the pump 45. The circulation passage yet further includes a passage 34 configured to lead the liquid 6, which is sent out of the pump 45, to the tank 43. In addition, the on-off valve 47 is connected to the tank 43 through an airtight passage 35. Descriptions will be hereinbelow provided for each of the components.

The housing 41 has a stand part 41b located in its rear potion and designed to come into contact with a grip part 52 of the electric shaver 50. The housing 41 holds the electric shaver 50, which is inserted through the opening 41a, in the receptacle 42. As shown in Fig. 10, contact members 41c configured to detect the mounting of the electric shaver 50 in the cleaning/purification apparatus 40 are provided in the front surface of the stand part 41b. The contact members 41c detect the mounting of the electric shaver 50 when the contact members 41c come into contact with terminals 52a provided on the rear surface of the grip part 52. In addition to the detection function, the contact members 41c are provided with functions to output various control signals and driving electric power.

A fan 48 configured to dry the head unit 51 after cleaning is housed in the front upper portion of the housing 41. Fan air slits 41d, a manipulation button 41e used for executing a cleaning operation, a lamp 41f configured to display the operational status, and the like are provided on the front surface of the housing 41. The rear-surface side of the housing 41 is formed into a mounting part to mount the tank 43, and is provided with connecting openings 41g, 41h, 41i which are connected to the respective openings 43a, 43b, 43c of the tank 43. The connecting opening 41g is connected to the pipe 30; the connecting opening 41h is connected to the passage 34; and the connecting opening 41i is connected to the airtight passage 35.

The receptacle 42 is formed into a recessed shape coinciding with the shape of the head unit 51. A through-hole 42b is formed in the bottom wall portion of the receptacle 42. The plasma generator 1 is provided behind the bottom wall portion of the receptacle 42 in a way that the liquid containing part 3 communicates with the inner space of the receptacle 42 through the through-hole 42b.

In this example, the plasma generator 1 is provided in a way that the liquid containing part 3 communicates with the inner space of the receptacle 42, and the inner space of the receptacle 42 likewise functions as the liquid containing part 3 of the plasma generator 1. Here, it is desirable that a drain groove or the like, for example, be formed in the receptacle 42 so as to smoothly discharge the liquid 6 in the liquid containing part 3 through the passage 31 (the discharge passage).

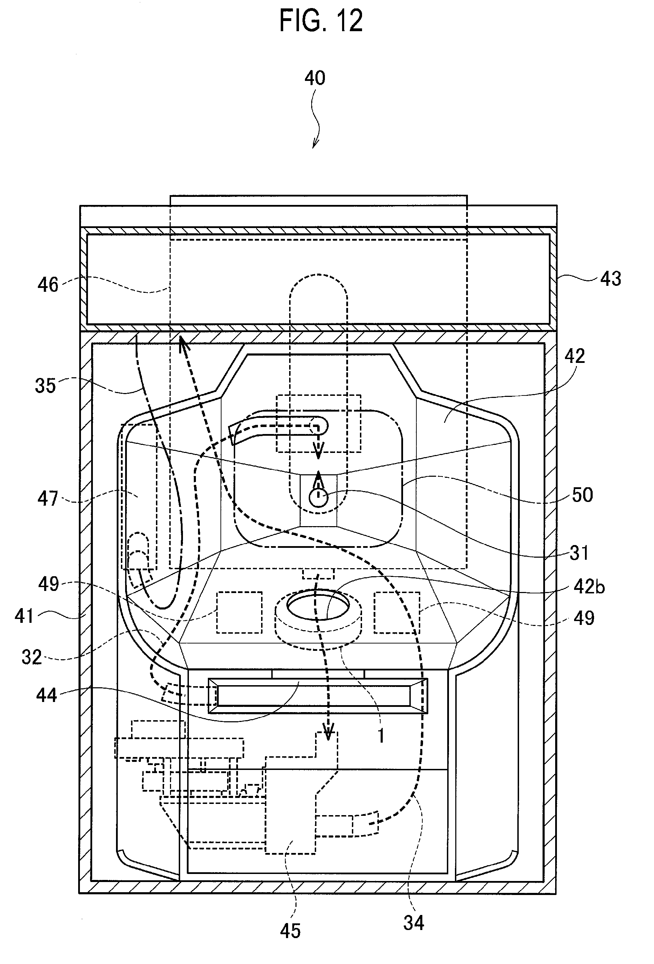

A heater 49 is provided behind the bottom-portion wall of the receptacle 42 (see Fig. 12). The heater 49 dries the head unit 51 in cooperation with the fan 48.

The overflow part 44 is provided in front of the receptacle 42. The receptacle 42 and the overflow part 44 are formed integrally. An inlet of the overflow part 44 is connected to the receptacle 42 and an outlet thereof is connected to the passage 32. The passage 32 extends from the outlet of the overflow part 44 to the cartridge 46 via a relay opening 42a provided behind the receptacle 42.

The discharge opening 43a, the inflow opening 43b, and the air opening 43c configured to release the airtight state are provided in the front surface of the tank 43. The discharge of the liquid through the discharge opening 43a is controlled by the opening and closing of the air opening 43c. The tank 43 is detachably attached to the rear-surface side of the housing 41. In addition, while the tank 43 is attached to the housing 41, the discharge opening 43a is connected to the connecting opening 41g so that the liquid stored in the tank 43 can be introduced into the receptacle 42 through the pipe (liquid introduction passage) 30. In addition, the inflow opening 43b is connected to the connecting opening 41h, and is thus connected to a delivery opening 45a of the pump 45 through the passage 34. The air opening 43c is connected to the connecting opening 41i, and is thus connected to the on-off valve 47 through the airtight passage 35.

The cartridge 46 is a substantially box-shaped body that houses the filter 46a inside. The cartridge 46 has an inflow opening 46b in its upper portion, and has an outflow opening 46c on its front portion. The cartridge 46 is detachably provided in the lower rear portion of the housing 41. While the cartridge 46 is attached to the housing 41, the inflow opening 46b is connected to a discharge opening 41k through the passage 31 (the discharge passage). In addition, the inflow opening 46b is connected to the outlet of the overflow part 44 through the passage 32. Furthermore, the outflow opening 46c is connected to a suction opening 45c of the pump 45 through the passage 33.

Next, descriptions will be provided for how the cleaning/purification apparatus 40 works. First of all, the liquid 6 is introduced into the receptacle 42 and the liquid containing part 3 of the plasma generator 1 from the tank 43 through the pipe (liquid introduction passage) 30.

Subsequently, the air-based gas including oxygen at the predetermined flow rate is delivered into the gas containing part 4 from the gas supply unit 9 through the pipe 8. In a case where the plasma generator 1 of the first embodiment is used, the control unit 14 controls the gas supply unit 9, and thus makes the pressure in the gas passage 5a higher than the pressure in the liquid containing part 3. Thereby, the gas containing part 4 is put into the positive pressure state, and the flow of the gas is created in the direction from the gas containing part 4 to the liquid containing part 3 through the gas passage 5a.

Thereafter, the predetermined voltage is applied between the first electrode 10 and the second electrode 11, and the electrical discharge is thereby caused between the first electrode 10 and the second electrode 11. This electrical discharge generates plasma in the gaseous area in the liquid 6 in the liquid containing part 3, and the ozone, the hydroxyl radicals, and the like are produced from the oxygen included in the water and the gas included in the liquid 6.

Then, the ozone and the various radicals thus produced are delivered into the liquid stored in the liquid containing part 3 and the receptacle 42 in conjunction with the flow of the gas. Here, the growing bubbles 16 are set free form the opening end 15 into the liquid as the bubbles 16 that are made fine by micronization means, and the fine bubbles 16 set free into the liquid disperse throughout the liquid. In other words, the produced cleaning liquid is supplied to the head unit 51. Then, the ozone and the radicals which dissolve in the liquid 6, as well as the ozone and the radicals included in the bubbles 16, decompose organic matters and the like which are attached to the head unit 51.

It should be noted that, although the cleaning/purification apparatus 40 of the 8th embodiment includes the plasma generator 1 of the first embodiment, the same effect can be obtained by using the plasma generator 1 of any one of the second to 7th embodiments. In other words, the cleaning/purification apparatus 40 using the plasma generator 1 of the present invention is capable of preventing the gas passage 5a from being clogged, and thus stably obtaining the radicals while keeping the stable electrical discharge state. The cleaning/purification apparatus 40 is accordingly capable of obtaining a high cleaning effect.

Although the foregoing descriptions have been provided for the preferable embodiments of the present invention, the present invention is not limited to the above-described embodiments and various modifications are possible.

For example, although in the above-described embodiments, the ceramic member is shown as an example of the partition wall part 5 provided with the gas passage 5a therein, the material of the partition wall part 5 is not limited to the ceramic member. For example, a material such a glass plate may be used to partition the gas and the liquid from each other with a fine hole (the gas passage 5a) formed in the material by photoengraving and etching. In this case, multiple gas passages 5a may be provided therein.

In addition, the cleaning/purification apparatus 40 of the present invention is not limited to what has been shown in the 8th embodiment. For example, the cleaning/purification apparatus 40 may be applied to a cleaning/purification apparatus for an electric toothbrush, a water-purification apparatus, an apparatus configured to purify water including a detergent and the like before its drainage, and the like.

Furthermore, detailed specifications (shape, size, layout and the like) of the liquid containing part 3, the gas containing part 4 and the others may be changed as needed.

The entire contents of Japanese Patent Application No. 2011-069481 (filed on March 28, 2011) are incorporated herein by reference.

Although the contents of the present invention have been described above with reference to the embodiments, the present invention is not limited to those descriptions. It is obvious to those skilled in the art that various modifications and improvements are possible.

### INDUSTRIAL APPLICABILITY

The plasma generator of the present invention includes the drainage promotion part. The drainage promotion part prevents the liquid in the liquid containing part from remaining in the gas passage after the liquid is drained. Thereby, the liquid does not remain in the gas passage after the drainage following the completion of the electrical discharge. For this reason, the impurities such as calcium are inhibited from being deposited through the water evaporation, and the gas passage is inhibited from being clogged with the impurities. Consequently, the plasma generator of the present invention is capable of obtaining the stable electrical discharge.

## Claims

1. A plasma generator comprising:
a liquid containing part configured to contain a liquid which includes water;
a gas containing part configured to contain a gas;
a partition wall part separating the liquid containing part and the gas containing part from each other and including a gas passage configured to lead the gas in the gas containing part to the liquid containing part;
a first electrode arranged in the gas containing part;
a second electrode arranged in contact with the liquid in the liquid containing part;
a gas supply unit configured to supply the gas including oxygen to the gas containing part in a way that the gas in the gas containing part is transferred to the liquid containing part through the gas passage by pressure;
a plasma power supply unit configured to turn the gas, which is transferred into the liquid in the liquid containing part by pressure, into plasma by causing electrical discharge between the first electrode and the second electrode through application of a predetermined voltage between the first electrode and the second electrode; and
a drainage promotion part configured to prevent the liquid in the liquid containing part from remaining in the gas passage after the liquid is drained.

2. The plasma generator of claim 1, wherein the drainage promotion part is formed from a projected part projecting from an opening peripheral portion of the gas passage beside the liquid containing part out from its surroundings.

3. The plasma generator of claim 2, wherein at least an inner surface of the gas passage or the projected part is formed from a hydrophobic member.

4. The plasma generator of claim 1 or 2, wherein as the drainage promotion part, at least an opening peripheral portion of the gas passage beside the liquid containing part is formed from a hydrophilic member.

5. The plasma generator of claim 1, wherein the drainage promotion part is formed from an air blowing mechanism configured to blow air to the gas passage.

6. The plasma generator of claim 1, wherein the drainage promotion part is formed from a vibration applying mechanism configured to apply vibrations to the gas passage.

7. The plasma generator of claim 5, wherein the air blowing mechanism uses the gas to be supplied from the gas supply unit to the gas containing part.

8. The plasma generator of claim 6, wherein the vibration applying mechanism uses vibrations originated from the gas supply unit.

9. A cleaning/purification apparatus comprising the plasma generator of any one of claims 1 to 8.

## Amended claims

### Amended claims under Art. 19.1 PCT

**1.** Amended) A plasma generator comprising:
a liquid containing part configured to contain a liquid which includes water;
a gas containing part configured to contain a gas;
a partition wall part separating the liquid containing part and the gas containing part from each other and including a gas passage configured to lead the gas in the gas containing part to the liquid containing part;
a first electrode arranged in the gas containing part;
a second electrode arranged in contact with the liquid in the liquid containing part;
a gas supply unit configured to supply the gas including oxygen to the gas containing part in a way that the gas in the gas containing part is transferred to the liquid containing part through the gas passage by pressure;
a plasma power supply unit configured to turn the gas, which is transferred into the liquid in the liquid containing part by pressure, into plasma by causing electrical discharge between the first electrode and the second electrode through application of a predetermined voltage between the first electrode and the second electrode; and
a drainage promotion part configured to prevent the liquid in the liquid containing part from remaining in the gas passage after the liquid is drained,
wherein the drainage promotion part is formed from a projected part projecting from an opening peripheral portion of the gas passage beside the liquid containing part out from its surroundings.

**2.** (Canceled)

**3.** (Amended) The plasma generator of claim 1, wherein at least an inner surface of the gas passage or the projected part is formed from a hydrophobic member.

**4.** (Amended) The plasma generator of claim 1, wherein as the drainage promotion part, at least an opening peripheral portion of the gas passage beside the liquid containing part is formed from a hydrophilic member.

**5.** The plasma generator of claim 1, wherein the drainage promotion part is formed from an air blowing mechanism configured to blow air to the gas passage.

**6.** The plasma generator of claim 1, wherein the drainage promotion part is formed from a vibration applying mechanism configured to apply vibrations to the gas passage.

**7.** The plasma generator of claim 5, wherein the air blowing mechanism uses the gas to be supplied from the gas supply unit to the gas containing part.

**8.** The plasma generator of claim 6, wherein the vibration applying mechanism uses vibrations originated from the gas supply unit.

**9.** (Amended) A cleaning/purification apparatus comprising the plasma generator of any one of claims 1 and 3 to 8.
